# EUROPEAN PATENT APPLICATION

(11) **EP 1 757 980 A1**
(43) Date of publication of application: **28.02.2007**
(21) Application number: 06118863.7
(22) Date of filing: 14.08.2006
(51) Int. Cl.: G03F 7/004, G03F 7/039

(54) **Radiation sensitive resin composition**

(30) Priority: 17.08.2005 JP 2005236523; 10.07.2006 JP 2006189133
(71) Applicant: JSR Corporation, Tokyo 104-8410 (JP)
(72) Inventor: Yoneda, Eiji, Tokyo Tokyo 104-8410 (JP); Sakakibara, Hirokazu, Tokyo Tokyo 104-8410 (JP); Nakashima, Hiromitsu, Tokyo Tokyo 104-8410 (JP); Nakagawa, Hiroki, Tokyo Tokyo 104-8410 (JP); Nishimura, Yukio, Tokyo Tokyo 104-8410 (JP)
(74) Representative: TBK-Patent

(57) **Abstract**

A radiation-sensitive resin composition which is a resist having properties such as excellent sensitivity, a small degree of line edge roughness of patterns, capability of inhibiting pattern collapsing, and the like is provided. The radiation-sensitive resin composition comprises an acid-dissociable group-containing polymer having recurring units of the following formulas (1-1) and (1-2), an additive of the following formula (1-3), and an acid generator, 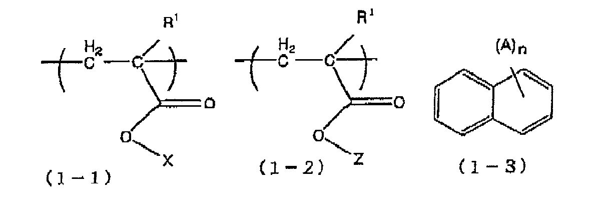 in the formula (1-1), R¹ represents a methyl group and the like and X represents a specific polycyclic alicyclic hydrocarbon group and the like, in the formula (1-2), R¹ represents a methyl group and the like and Z represents an acid-dissociable group which is dissociable by the action of an acid, and in the formula (1-3), n is an integer from 1-8 and A individually represents a hydroxyl group and the like.

## Description

### BACKGROUND OF THE INVENTION

Field of the Invention

The present invention relates to a radiation-sensitive resin composition and, more particularly, to a radiation-sensitive resin composition suitable as a chemically-amplified resist useful for microfabrication utilizing various types of radiation, for example, deep ultraviolet rays such as a KrF excimer laser orArF excimer laser, X-rays such as synchrotron radiation, or charged particle rays such as electron beams.

Background Art

In the field of microfabrication represented by fabrication of integrated circuit devices, a photolithographic technology enabling microfabrication with a line width of about 100 nm or less using an ArF excimer laser (wavelength: 193 nm). F₂ excimer laser (wavelength: 157 nm), and the like has been demanded in recent years in order to achieve a higher degree of integration. As a radiation-sensitive resin composition applicable to the excimer laser radiation, a number of chemically-amplified radiation-sensitive compositions utilizing a chemical amplification effect by a component having an acid-dissociable functional group and a photoacid generator which is a component generating an acid upon irradiation have been proposed. For example, a high molecular compound for a photoresist containing a polymer having a specific structure, which contains a monomer unit with a norbornane ring derivative, as a resin component, has been known (refer to Patent Documents 1 and 2). In addition, a radiation-sensitive resin composition prepared by adding an optically active compound to a composition comprising a component having an acid-dissociable functional group and an acid generator in order to promote sensitivity and resolution has been disclosed (refer to Patent Document 3).

However, a higher sensitivity and resolution are required for radiation-sensitive resin compositions used as a resist due to a demand of higher integrity in the semiconductor field. At the same time, demands for reducing line edge roughness (LER) of patterns, inhibiting pattern collapsing, and maintaining excellent pattern profile have increased as miniaturization proceeds. Along with progress of miniaturization in the semiconductor industry, development of a radiation-sensitive resin composition having excellent sensitivity and resolution, exhibiting only a small degree of line edge roughness of patterns, capable of inhibiting pattern collapsing, and capable of maintaining excellent pattern profile is a subject of an urgent need.

More recently, a liquid immersion lithographic method has been reported. In this method, a layer of a liquid refractive-index medium (a dipping liquid) with a predetermined thickness, such as pure water or a fluorine-containing inert liquid, is caused to be present between a lens and a resist film on a substrate, at least on the surface of the resist film at the time of exposure. According to this method, a conventionally used inert gas atmosphere in the light-path space, such as air and nitrogen, is replaced by a liquid with a larger refractive index (n), for example, pure water, whereby resolution can be increased without a decrease in focal depth by using a light source with a given wavelength to the same degree as in the case in which a light source with a shorter wavelength is used or the case in which a higher NA lens is used. Since a resist pattern with a higher resolution excelling in focal depth can be formed at a low cost using the lens mounted in existing apparatuses by using the liquid immersion lithographic method, the method have gotten a great deal of attention.

Even in the liquid immersion lithographic method excelling in resolution and other performance, the demand for inhibiting pattern collapsing remains, but rather increases along with progress of miniaturization. Although several resins for the resist used in a liquid immersion lithographic apparatus have been proposed (for example, Patent Documents 4 and 5), any resins cannot effectively inhibit pattern collapsing. Further reduction of pattern collapsing has been strongly desired.
[Patent Document 1] JP-A-2002-201232
[Patent Document 2] JP-A-2002-145955
[Patent Document 3] JP-A-2002-363123
[Patent Document 4] WO 2004/068242
[Patent Document 5] JP-A-2005-173474

### SUMMARY OF THE INVENTION

An object of the present invention is to provide a radiation-sensitive resin composition which is a chemically-amplified resist having excellent sensitivity and resolution, exhibiting only a small degree of line edge roughness of patterns, capable of inhibiting pattern collapsing, and capable of maintaining excellent pattern profile, particularly a radiation-sensitive resin composition having superior sensitivity and pattern collapsing inhibiting capability when a liquid immersion lithographic method is employed.

The present invention provides the following radiation-sensitive resin compositions solving the above problems.

[1] A radiation-sensitive resin composition comprising: (A) an acid-dissociable group-containing polymer having a recurring unit of the following formula (1-1) and a recurring unit having an acid-dissociable group of the following formula (1-2), (B) an additive of the following formula (1-3), and (C) an acid generator which generates an acid by being irradiated with radiation.

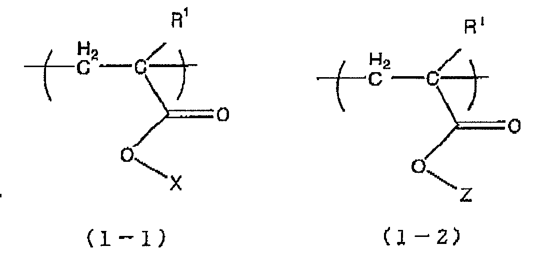

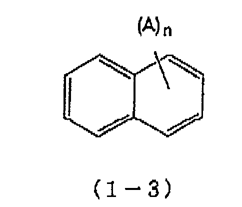

in the formula (1-1), R¹ represents a hydrogen atom, a methyl group, or a trifluoromethyl group and X represents a substituted or unsubstituted polycyclic alicyclic hydrocarbon group having 4-20 carbon atoms or a group having a lactone skeleton, in the formula (1-2), R¹ represents a hydrogen atom, a methyl group, or a trifluoromethyl group and Z represents an acid-dissociable group which is dissociable by the action of an acid, and in the formula (1-3), n is an integer from 1-8 and A individually represents a hydroxyl group and/or a monovalent organic group.

[2] The radiation-sensitive resin composition according to [1], wherein X in the formula (1-1) is a polycyclic alicyclic hydrocarbon group having 4-20 carbon atoms, which does not contain any polar group and consists only of carbon atoms and hydrogen atoms, an adamantyl group containing a hydroxyl group in the side chain, or a group having a lactone skeleton.

[3] The radiation-sensitive resin composition according to [1], wherein Z in the formula (1-2) is a trialkylmethyl group, an alkylcycloalkyl group, or an alkyladamantyl group.

[4] The radiation-sensitive resin composition according to [1], wherein the acid generator which generates an acid by being irradiated with radiation is a sulfonium salt compound.

[5] The radiation-sensitive resin composition according to [4], wherein the acid generator which generates an acid by being irradiated with radiation is contained in an amount of 0.1 to 30 parts by mass per 100 parts by mass of the polymer.

[6] The radiation-sensitive resin composition according to [4], further comprising an acid diffusion controller.

[7] The radiation-sensitive resin composition according to [6], wherein the acid diffusion controller is a compound containing an amide group.

[8] The radiation-sensitive resin composition according to [1], wherein at least one group represented by A in the formula (1-3) is a hydroxyl group or a group represented by ―O-R², wherein R² represents a linear or branched alkyl group having 1-10 carbon atoms or an alicyclic substituent having 1-10 carbon atoms.

[9] The radiation-sensitive resin composition according to [1], wherein at least one group represented by A in the formula (1-3) is a group represented by the following formula (2),

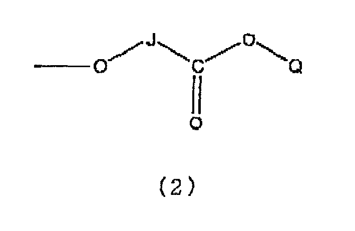

wherein J indicates a single bond, a methylene group, or a linear or branched alkylene group having 2-10 carbon atoms, and Q represents an acid-dissociable group which is dissociable by the action of an acid.

[10] The radiation-sensitive resin composition according to [1], wherein the additive represented by the formula (1-3) is contained in an amount of 0.5 to 10 parts by mass per 100 parts by mass of the polymer.

[11] A method for forming a pattern, comprising irradiating the radiation-sensitive resin composition according to [1] with radiation by means of a liquid immersion lithographic method.

The radiation-sensitive resin composition of the present invention not only possesses excellently balanced characteristics such as sensitivity and resolution as a chemically-amplified resist responsive to active radiations, particularly to deep ultraviolet rays represented by an ArF excimer laser (wavelength: 193 nm), but also can inhibit pattern collapsing phenomenon by increasing adhesion to a substrate, produce excellent resist pattern profile after development, and reduce line edge roughness of patterns.

### DETAILED DESCRIPTION OF THE INVENTION AND PREFERRED EMBODIMENT

A best mode for carrying out the present invention (hereinafter referred to as "embodiment") will be described below. However, it should be understood that the present invention is not limited to the following embodiment, and various modifications and improvements of the design may be made within the scope of the present invention based on the knowledge of a person having an ordinary skill in the art.

### (Radiation sensitive resin composition)

The radiation-sensitive resin composition of this embodiment comprises: (A) an acid-dissociable group-containing polymer (hereinafter referred to from time to time as "polymer (A)") having a recurring unit of the following formula (1-1) and a recurring unit having an acid-dissociable group of the following formula (1-2), which is insoluble or scarcely soluble in alkali, but becoming alkali soluble by the action of an acid, (B) an additive shown by the following formula (1-3) (hereinafter referred to from time to time as "additive (B)"), and (C) an acid generator which generates an acid by being irradiated with radiation (hereinafter referred to from time to time as "acid generator (C)").

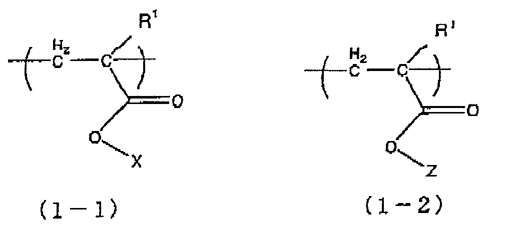

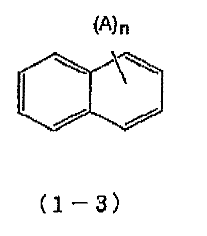

In the formula (1-1), R¹ represents a hydrogen atom, a methyl group, or a trifluoromethyl group and X represents a substituted or unsubstituted polycyclic alicyclic hydrocarbon group having 4-20 carbon atoms or a group having a lactone skeleton, in the formula (1-2), R¹ represents a hydrogen atom, a methyl group, or a trifluoromethyl group and Z represents an acid-dissociable group which is dissociable by the action of an acid, and in the formula (1-3), n is an integer of 1 to 8 and A individually represents a hydroxyl group and/or a a monovalent organic group.

Because the radiation-sensitive resin composition ofthis embodiment contains the additive (B) and the acid generator (C) as mentioned above, an acid is effectively generated from the acid generator (C) when the resin composition is used as a chemically-amplified resist and irradiated with light by having the additive (B) function as a sensitizer. As a result, the acid can be generated uniformly all over the resist. By causing the acid to be generated uniformly all over the resist in this manner, it is possible to cause the acid-dissociable group possessed by the polymer (A) to homogeneously dissociate all over the resist, resulting particularly in reduction of line edge roughness of patterns after development. In addition, because the additive (B) increases adhesion of the resist to a substrate, collapsing of patterns can be inhibited. Here, pattern collapsing refers to a phenomenon in which line patterns collapse due to miniaturization.

### <Polymer (A)>

The polymer (A) forming the radiation-sensitive resin composition of this embodiment is a copolymer having a recurring unit of the above formula (1-1) (hereinafter referred to from time to time as "recurring unit (1-1)") and a recurring unit having an acid-dissociable group of the above formula (1-2) (hereinafter referred to from time to time as "recurring unit (1-2)"). Although the recurring unit (1-2) is an alkali-insoluble or scarcely alkali soluble unit, this unit has an acid-dissociable group and dissociates the acid-dissociable group by the action of an acid, thereby becoming soluble in alkali. In the above formula (1-2), the acid-dissociable group is a carboxyl group protected by a protective group Z. The term "alkali-insoluble" or "scarcely alkali-soluble" used herein indicates the following properties of a polymer. In the case of developing a film using only the polymer (A) instead of a resist film formed from the radiation-sensitive resin composition containing the polymer (A) under alkaline development conditions employed when forming a resist pattern using the resist film, the term "alkali-insoluble" or "scarcely alkali-soluble" refers to properties in which 50% or more of the initial thickness of the film remains after development. The same is applied to in the following description.

In the formula (1-1), R¹ represents a hydrogen atom, a methyl group, or a trifluoromethyl group and X represents a substituted or unsubstituted polycyclic alicyclic hydrocarbon group having 4-20 carbon atoms or a group having a lactone skeleton. As examples of the polycyclic alicyclic hydrocarbon group, alicyclic hydrocarbon groups originating from cycloalkanes such as bicyclo[2.2.1]heptane (1a), bicyclo[2.2.2]octane (1b), tricyclo[5.2.1.0^{2,6}]decane (1c), tetracyclo[4.4.0.1^{2,5}.1^{7,10}]dodecane (1d), and adamantane (1e), as shown in the following formulas (1a) to (1e), can be given.

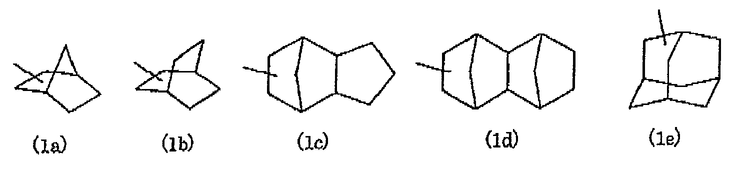

These alicyclic groups originating from cycloalkanes may have a substituent. As preferable substituents, linear, branched, or cyclic alkyl groups having 1-4 carbon atoms such as a methyl group, ethyl group, n-propyl group, i-propyl group, n-butyl group, 2-methylpropyl group, 1-methylpropyl group, and t-butyl group can be given. An alicyclic ring having one or more these groups as a substituent is also preferable. Specific examples include, but are not limited to, groups shown by the following formulas (1f) to (11). These groups may be used either individually or in combination of two or more.

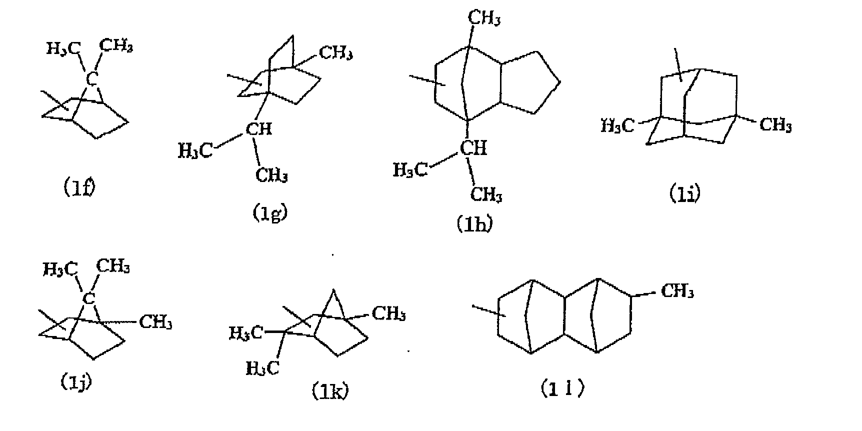

As examples of the recurring units shown by the general formula (1-I) having other polycyclic alicyclic hydrocarbon groups, recurring units shown by the following formulas (3a-i) to (3a-iv) can be given. Possession of the recurring unit shown by the formula (3a) by the acid-dissociable group-containing resin increases dry etching resistance of the resist resulting from the radiation-sensitive resin composition of the present invention, and particularly ensures an extremely smooth resist surface after dry etching. In addition, because the acid generated by irradiation with light moderately diffuses, pattern surface roughness can be improved.

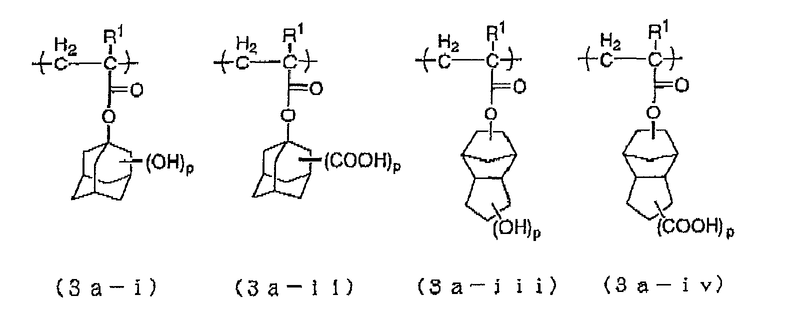

In the formulas (3a-i) to (3a-iv), R¹ represents a hydrogen atom, a methyl group, or a trifluoromethyl group, and p is an integer of 1 to 3.

As the recurring units represented by the formula (3 a), the units shown by the following formulas (3a-1) and (3a-2) are particularly preferable.

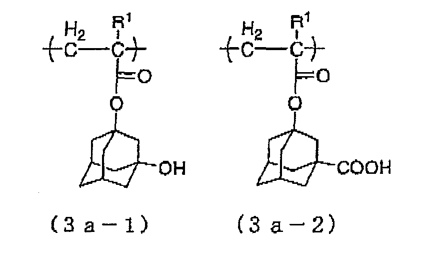

In the formulas (3a-1) and (3a-2), R¹ represents a hydrogen atom, a methyl group, or a trifluoromethyl group.

When X in the above formula (1-1) is a group having a lactone skeleton, lactone skeleton-containing recurring units of the following formulas (3b-i) to (3b-viii) can be given as examples of the recurring unit (1-1).

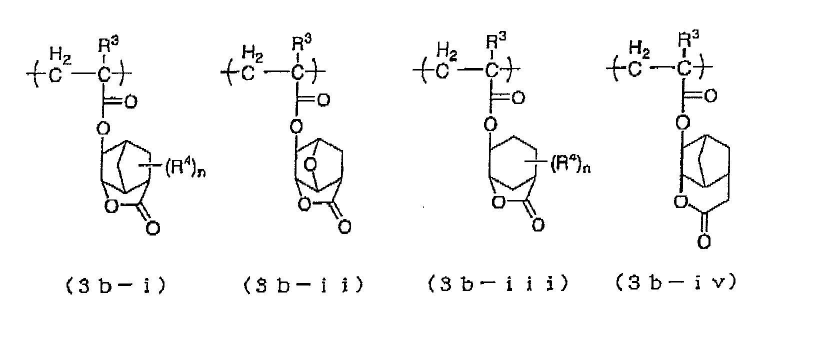

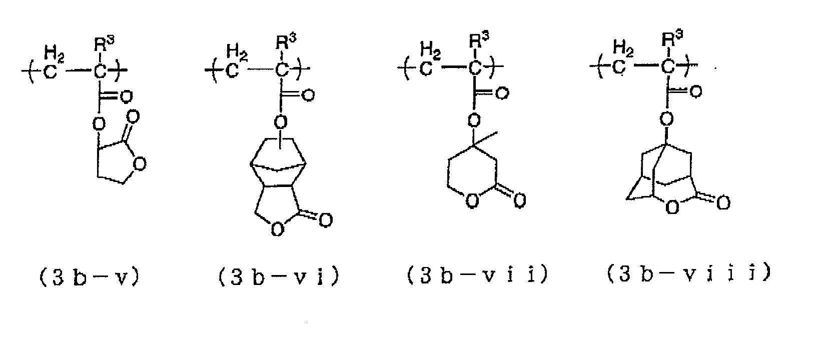

In the formulas (3b-i) to (3b-viii), R³ represents a hydrogen atom, a methyl group, or a trifluoromethyl group and R⁴ individually represents a hydrogen atom, a linear or branched alkyl group having 1-4 carbon atoms, a linear or branched alkoxy group having 1-4 carbon-atoms, or a linear or branched fluoroalkyl group having 1-4 carbon-atoms. n is an integer of 0-3.

Among the lactone skeleton-containing recurring units represented by the above formula (3b), particularly preferable lactone skeleton-containing recurring units are structures shown by the following formulas (3b-1) to (3b-3).

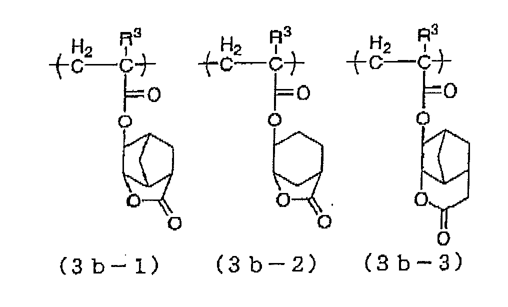

In the formulas (3b-1) to (3b-3), R³ represents a hydrogen atom, a methyl group, or a trifluoromethyl group.

Preferable examples of the monomer providing the recurring unit (1-1) include: bicyclo[2.2.1]hept-2-yl (meth)acrylate, bicyclo[2.2.2]oct-2-yl (meth)acrylate, tricyclo[5.2.1.0^{2,6}]dec-7-yl (meth)acrylate, tetracyclo[6.2.1.1^{3,6}.0^{2,7}]dodec-9-yl (meth)acrylate, tricyclo[3.3.1.1^{3,7}]dec-1-yl (meth)acrylate, tricyclo[3.3.1.1^{3,7}]dec-2-yl (meth)acrylate, 3-hydroxyadamantane-1-ylmethyl (meth)acrylate, 3,5-dihydroxyadamantane-1-ylmethyl (meth)acrylate, 3-carboxyladamantane-1-ylmethyl (meth)acrylate, 3-hydroxy-5-methyladamantane-1-yl (meth)acrylate, 3,5-dihydroxy-7-methyladamantane-1-yl (meth)acrylate, 3-hydroxy-5,7-dimethyladamantane-1-yl (meth)acrylate, 3-carboxyl-5,7-dimethyladamantane-1-yl (meth)acrylate, 3-hydroxy-5,7-dimethyladamantane-1-ylmethyl (meth)acrylate, 5-oxo-4-oxatricyclo[4.2.1.0^{3,7}]non-2-yl (meth)acrylate, 9-methoxycarbonyl-5-oxo-4-oxatricyclo[4.2.1.0^{3,7}]non-2-yl (meth)acrylate, 5-oxo-4-oxatricyclo[5.2.1.0^{3,8}]dec-2-yl (meth)acrylate, 10-methoxycarbonyl-5-oxo-4-oxatricyclo[5.2.1.0^{3,8}]non-2-yl (meth)acrylate, 6-oxo-7-oxabicyclo[3.2.1]oct-2-yl (meth)acrylate, 4-methoxycarbonyl-6-oxo-7-oxabicyclo[3,2,1]oct-2-yl (meth)acrylate, 7-oxo-8-oxabicyclo[3.3.1]oct-2-yl (meth)acrylate, 4-methoxycarbonyl-7-oxo-8-oxabicyclo[3.3.1]oct-2-yl (meth)acrylate, 2-oxotetrahydropyrarl-4-yl (meth)acrylate, 4-methyl-2-oxotetrahydropyran-4-yl (meth)acrylate, 4-ethyl-2-oxotetrahydropyran-4-yl (meth)acrylate, 4-propyl-2-oxotetrahydropyran-4-yl (meth)acrylate, 5-oxotetrahydrofuran-3-yl (meth)acrylate, 2,2-dimethyl-5-oxotetetrahydrofuran-3-yl (meth)acrylate, 4,4-dimethyl-5-oxotetetrahydrofuran-3-yl (meth)acrylate, 2-oxotetrahydrofuran-3-yl (meth)acrylate, 4,4-dimethyl-2-oxotetetrahydrofuran-3-yl (meth)acrylate, 5,5-dimethyl-2-oxotetetrahydrofuran-3-yl (meth)acrylate, 2-oxotetrahydrofuran-3-yl (meth)acrylate, 5-oxotetetrahydrofuran-2-ylmethyl (meth)acrylate, 3,3-dimethyl-5-oxotetetrahydrofuran-2-ylmethyl (meth)acrylate, 4,4-dimethyl-5-oxotetetrahydrofuran-2-ylmethyl (meth)acrylate, and the like. Either one type or two or more types of the recurring units originating from these monomers may be present in the polymer (A).

In the above formula (1-2), R¹ is a hydrogen atom, methyl group, or trifluoromethyl group, and Z is an acid-dissociable group which dissociates by the action of an acid. As the recurring unit comprising the acid-dissociable group shown by the formula (1-2), the recurring units of the following formulas (4) and (5) are preferable.

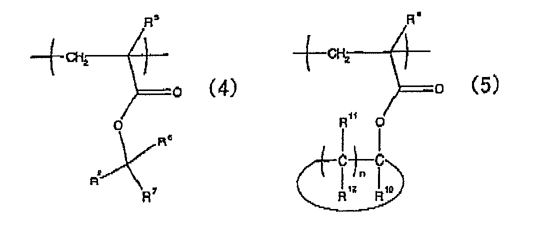

wherein R⁵ and R⁹ individually represent a hydrogen atom, methyl group, or trifluoromethyl group, R⁶, R⁷, and R⁸ individually represent a linear or branched alkyl group having 1-4 carbon atoms or an alicyclic hydrocarbon group having 4-20 carbon atoms, any two of the R⁶, R⁷, and R⁸ groups may combine to form a polycyclic aliphatic hydrocarbon group having 6-20 carbon atoms, R¹⁰ is a linear or branched alkyl group having 1-4 carbon atoms, R¹¹ and R¹² individually represent a hydrogen atom or a linear or branched alkyl group having 1-4 carbon atoms, and n is an integer from 3 to 7.

As examples of the linear or branched alkyl group having 1-4 carbon atoms represented by R⁶, R⁷, and R⁸, a methyl group, ethyl group, n-propyl group, i-propyl group, n-butyl group, 2-methylpropyl group, 1-methylpropyl group, and t-butyl group can be given. As examples of the alicyclic hydrocarbon group having 4-20 carbon atoms, cyclobutane, cyclopentane, cyclohexane, cycloheptane, cyclooctane, bicyclo[2.2.1]heptane, bicyclo[2.2.2]octane, tricyclo[5.2.1.0^{2,6}]decane, tetracyclo[4.4.0.1^{2,5}.1^{7,10}]dodecane, adamantane, or hydrocarbon groups originating from derivatives of these compounds can be given. Examples of R⁵ include a hydrogen atom, methyl group, and trifluoromethyl group.

As examples of the polycyclic aliphatic hydrocarbon having 6-20 carbon atoms formed from any two of the R⁶, R⁷, and R⁸ groups, bicyclo[2.2.1]heptane, bicyclo[2.2.2]octane, tricyclo[5.2.1.0^{2,6}]decane, tetracyclo[4.4.0.1^{2,5}.1^{7,10}]dodecane, adamantane, or hydrocarbon groups originating from derivatives of these compounds can be given.

As examples of R¹⁰ in the formula (5), a methyl group, ethyl group, n-propyl group, i-propyl group, n-butyl group, 2-methylpropyl group, 1-methylpropyl group, and t-butyl group can be given. As examples of R¹¹ and R¹², a hydrogen atom, methyl group, ethyl group, n-propyl group, i-propyl group, n-butyl group, 2-methylpropyl group, 1-methylpropyl group, and t-butyl group can be given. Examples of R⁹ includes a hydrogen atom, methyl group, or trifluoromethyl group.

In the formula (5), it is particularly preferable that R¹⁰ is a methyl group or ethyl group, R¹¹ and R¹² is a hydrogen atom, and n is 4 or 5. The following formulas (5-1) to (5-4) can be given as particularly preferable examples.

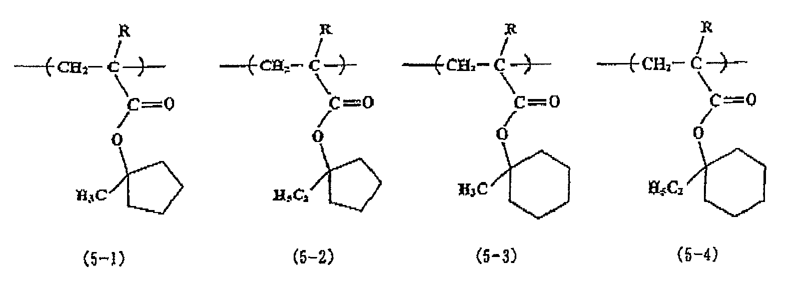

wherein R individually represents a hydrogen atom, methyl group, or trifluoromethyl group.

Preferable examples of the monomer providing the recurring unit (1-2) include: t-butyl (meth)acrylate, 2-methyladamantane-2-yl (meth)acrylate, 2-methyl-3-hydroxyadamantane-2-yl (meth)acrylate, 2-ethyladamantane-2-yl (moth)acrylate, 2-ethyl-3-hydroxyadamantane-2-yl (meth)acrylate, 2-n-propyladamantane-2-yl (meth)acrylate, 2-isopropyladarnantane-2-yl (meth)acrylate, 2-methylbicyclo[2,2,1]hept-2-yl (meth)acrylate, 2-ethylbicyclo[2.2.1]hept-2-yl (meth)acrylate, 8-methyltricyclo[5.2.1.0^{2,6}]decan-8-yl (meth)acrylate, 8-ethyltricyclo[5.2,1.0^{2,6}]decan-8-yl (meth)acrylate, 4-methyltetracyclo[6.2.1^{3,5}.0^{2,7}]dodecan-4-yl (meth)acrylate, 4-ethyltetracyclo[6.2.1^{3,6}.0^{2,7}]dodecan-4-yl (meth)acrylate, 1-(bicyclo[2.2.1]hept-2-yl)-1-methylethyl (meth)acrylate, 1-(tricyclo[5.2.1.0^{2,6}decan-8-yl)-1-methylethyl (meth)acrylate, 1-(tetracyclo[6.2.1^{3,6}.0^{2,7}]dodecan-4-yl)-1-methylethyl (meth)acrylate, 1-(adamantane-1-yl)-1-methylethyl (meth)acrylate, 1-(3-hydroxyadanmtane-1-yl)-1-methylethyl (meth)acrylate, 1,1-dicyclohexylethyl (meth)acrylate, 1,1-di(bicyclo[2.2.1]hept-2-yl)ethyl (meth)acrylate, 1, 1-di(tricyclo[5.2.1.0^{2,6}]decan-8-yl)ethyl (meth)acrylate, 1, 1-di(tetracyclo[6.2.1^{3,6}.0^{2,7}]dodecan-4-yl)ethyl (meth)acrylate, 1,1-di(adamantane-1-yl)ethyl (meth)acrylate, 1-methyl-1-cyclopentyl (meth)acrylate, 1-ethyl-1-cyclopentyl (meth)acrylate, 1-methyl-1-cyclohexyl (meth)acrylate, 1-ethyl-1-cyclohoxyl (meth)acrylate, and the like. Either one type or two or more types of recurring units originating from these monomers may be present in the polymer (A).

Of these monomers, t-butyl (meth)acrylate, 2-methyladamantane-2-yl (meth)acrylate, 2-ethyladamantane-2-yl (meth)acrylate, 2-methylbicyclo[2.2.1]hept-2-yl (meth)acrylate, 2-ethylbicyclo[2.2.1]hept-2-yl (meth)acrylate, 1-(bicyclo[2,2.1]hept-2-yl)-1-methylethyl (meth)acrylate, 1-(adamantane-1-yl)-1-methylethyl (meth)acrylate. 1-methyl-1-cyclopentyl (meth)acrylate, 1-ethyl-1-cyclopentyl (meth)acrylate, 1-methyl-1-cyclohexyl (meth)acrylate, and 1-ethyl-1-ayclohexyl (meth)acrylate are particularly preferable. Either one type or two or more types of the recurring units (1-2) may be present in the polymer (A).

The mol ratio of the recurring unit (1-1) and recurring unit (1-2), (1-1):(1-2), in the polymer (A) is preferably 10:90 to 90:10 and particularly preferably 30:70 to 70:30. The above range makes it possible to obtain a dissolution contrast suitable for pattern formation, good resolution, LER, pattern profile, and the like. If the amount of the recurring unit (1-1) is too small (the amount of the recurring unit (1-2) is too great), a suitable dissolution contrast cannot be obtained, which may result in decreased resolution, and if the amount of the recurring unit (1-1) is too great (the amount of the recurring unit (1-2) is too small), a suitable pattern profile cannot be obtained due to low dissolution contrast during developing.

In the present embodiment, either one type of the polymer (A) can be used alone or two or more polymers (A) can be used in combination. The polymer (A) is usually insoluble or scarcely soluble in alkali, but becomes easily soluble in alkali by the action of an acid.

### (Additive (B))

The additive (B) used in the radiation-sensitive resin composition of the present invention is a compound having a naphthalene skeleton shown by the above formula (1-3). In the formula (1-3), n is an integer from 1 to 8 and A individually represents a hydroxyl group and/or a monovalent organic group. The monovalent organic group represented by A is preferably at least one group selected from the group consisting of a carboxyl group, ether group, and ester group. When A is an ester group, the carbonyl group (carbon atom) side of the ester group is preferably bonded to naphthalene. In addition, A is preferably bonded to the naphthalene skeleton at the first or second position.

When A is an ether group, A is preferably a group -O-R², wherein R² represents a hydrogen atom or a linear or branched alkyl group having 1-10 carbon atoms or an alicyclic substituent having 1-10 carbon atoms. As examples of the alicyclic substituent having 1-10 carbon atoms, a cyclopropyl group, cyclobutyl group, cyclopentyl group, cyclohexyl group, cycloheptyl group, cyclooctyl group, and the like can be given. When A is an ester group, A is preferably a methyl ester group, ethyl ester group, n-propyl ester group, i-propyl ester group, n-butyl ester group, t-butyl ester group, or the like, provided that the carbon atom of the carbonyl group forming the ester group is preferably bonded to naphthalene.

When the radiation-sensitive resin composition comprising the above additive (B) of the present invention is used as a chemically-amplified resist and irradiated, the naphthalene skeleton of the additive (B) absorbs light (radiation) energy and is excited. The excited energy can be used for generation of an acid by the acid generator (C). The acid generator (C) absorbs the excited energy from the additive (B) in an excited state and becomes excited. In the irradiated area, in addition to the acid produced by conventional radiation, the acid is generated by the acid generator (C) which absorbs energy from the additive (B) excited by the above effect. In addition, radicals are thought to be produced from the additive (B) brought to an excited state and transferred to the acid generator, whereby an acid is also generated. As a result of this sensitization, the entire irradiated area can effectively and uniformly produce acid. As a result, since the acid-dissociable group of the polymer (A) in the irradiated area can be uniformly dissociated, line edge roughness of the pattern after development can be decreased in particular and pattern collapsing can be inhibited.

As the A of the additive (B), the group of the following formula (2) is also preferable.

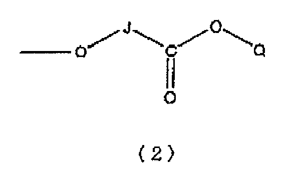

wherein J is a single bond, a methylene group, or a linear or branched alkylene group having 2-10 carbon atoms and Q is an acid-dissociable group which dissociates by the action of an acid. As examples of Q, a t-butyl group, methylcyclopentyl group, ethylcyclopentyl group, methylcyclohexyl group, ethylcyclohexyl group, methyladamantyl group, ethyladamantyl group, and the like can be given. Such a structure A ensures an improved dissolution contrast and high resolution of a resist when the radiation-sensitive resin composition of the present embodiment is used as a chemically-amplified resist.

As preferable examples of the compound shown by the formula (1-3), 1-naphthol, 2-naphthol, 1,8-naphthalenediol, 1-naphthalenecarboxylic acid, 2-naphthalenecarboxylic acid, 1,8-naphthaIenedicarboxylic acid, 1-nnethoxynaphthalene, 2-methoxynaphthalene, 1-ethoxynaphthalene, 2-ethoxynaphthalene, 1-n-propoxynaphthatene, 2-n-propoxynaphthalene, 1-i-propoxynaphthalene, 2-i-propoxynaphthalene, 1-n-butoxynaphthalene, 2-n-butoxynaphthalene, 1-methoxycarbonylnaphthalene, 1-t-butoxycarbonylnaphthalene, 1-(methoxycarbonylmethoxy)naphthalene, and 1-(t-butoxycarbonylmethoxy)naphthalene can be given. As particularly preferable examples of the compound shown by the formula (1-3), the compounds of the following formulas (1-3a) to (1-3e) can be given.

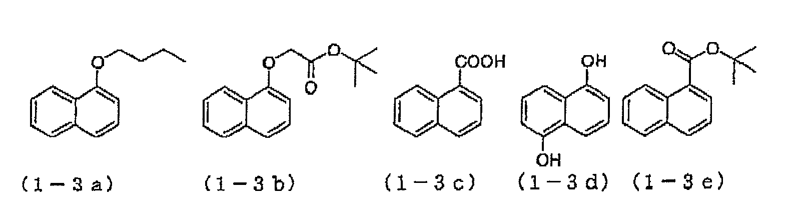

In the present embodiment, either one type of the additive (B) can be used alone or two or more types may be used in combination. In view of decreasing line edge roughness and inhibiting pattern collapsing, the additive (B) is preferably used in an amount of 0.5 to 10 parts by mass and particularly preferably 1 to 5 parts by mass for 100 parts by mass of the polymer (A). If the additive (B) is used in an amount less than 0.5 part by mass, decrease in line edge roughness and control of pattern collapsing may not be sufficient, and if used in an amount exceeding 10 parts by mass, a good pattern profile may not be obtained due to absorption by the additive.

### Acid generator (C)

As the acid generator (C) of the radiation-sensitive resin composition of the present embodiment, onium salt compounds such as sulfonium salts and iodonium salts, organo halide compounds, sulfone compounds such as disulfones and diazomethane sulfones, and the like can be given.

As preferable specific examples of the acid generator (C), triphenylsulfonium salt compounds such as triphenylsulfonium trifluoromethanesulfonate, triphenylsulfonium nonafluoro-n-butanesulfonate, triphenylsulfonium perfluoro-n-octanesulfonate, triphenylsulfonium 2-bicyclo[2.2.1]hept-2-yl-1,1,2,2-tetrafluoroethanesulfonate, triphenylsulfonium camphorsulfonate, and triphenylsulfonium 2-(bicyclo[2.2.1]hept-2'-yl)-1,1-difluoroethanesulfonate;

4-cyclohexylphenyldiphenylsulfonium salt compounds such as 4-cyclohexylphenyldiphenylsulfonium trifluoromethanesulfonate, 4-cyclohexylphenyldiphenylsulfonium nonafluoro-n-butanesulfonate, 4-cyclohexylphenyldiphenylsulfonium perfluoro-n-octanesulfonate, 4-cyclohexylphenyldiphenylsulfonium 2-bicyclo[2.2.1]hept-2-yl-1,1,2,2-tetrafluoroethanesulfonate, 4-cyclohexylphenyldiphenylsulfonium camphorsulfonate, and 4-cyclohexylphenyl-diphenylsulfonium 2-(bicyclo[2.2.1]hept-2'-yl)-1,1-difluoroethanesulfonate;

tri-t-butylphenylsulfonium salt compounds such as tri-t-butylphenylsulfonium trifluoromethanesulfonate, tri-t-butylphenylsulfonium nonafluoro-n-butanesulfonate, tri-t-butylphenylsulfonium perfluoro-n-octanesulfonate, tri-t-butylphenylsulfonium 2-bicyclo[2.2.1]hept-2-yl-1,1,2,2-tetrafluoroethanesulfonate, tri-t-butylphenylsulfonium camphorsulfonate, and tri-t-butylphenylsulfonium 2-(bicyclo[2,2.1]hept-2'-yl)-1, 1-difluoroethanesulfonate;

4-methanesulfonylphenyldiphenylsulfonium salt compounds such as 4-methanesulfonylphenyldiphenylsulfonium trifluoromethanesulfonate, 4-methanesulfonylphenyldiphenylsulfonium nonafluoro-n-butanesulfonate, 4-methanesulfonylphenyldiphenylsulfonium perfluoro-n-octanesulfonate, 4-methanesulfonylphenyldiphenylsulfonium 2-bicyclo[2.2.1]hept-2-yl-1,1,2,2-tetrafluoroethanesulfonate, 4-methanesulfanylphenyldiphenylsulfanium camphorsulfonate, and 4-methanesulfonylphenyldiphenylsulfonium 2-(bicyclo[2.2.1]hept-2'-yl)-1,1-difluoroethanesulfonate;

diphenyliodonium salt compounds such as diphenyliodonium trifluoromethanesulfonate, diphenyliodonium nonafluoro-n-butanesulfonate, diphenyliodonium perfluoro-n-octanesulfonate, diphenyliodonium 2-bicyclo[2.2.1]hept-2-yl-1,1,2,2-tetrafluoroethanesuffonate, and diphenyliodonium camphorsulfonate;

bis(4-t-butylphenyl)iodonium salt compounds such as bis(4-t-butylphenyl)iodonium trifluoromethanesulfonate, bis(4-t-butylphenyl)iodonium nonafluoro-n-butancsulfonate, bis(4-t-butylphenyl)iodonium perfluoro-n-octanesulfonate, bis(4-t-butylphenyl)iodonium 2-bicyclo[2.2.1]hept-2-yl-1,1,2,2-tetrafluoroethanesulfonate, and bis(4-t-butylphenyl)iodonium camphorsulfonate;

1-(4-n-butoxynaphthalen-1-yl)tetrahydrothiophenium salt compounds such as 1-(4-n-butoxynaphthalen-1-yl)tetrahydrothiophenium trifluoromethanesulfonate, 1-(4-n-butoxynaphthalen-1-yl)tetrahydrothiophenium nonafluoro-n-butanesulfonate, 1-(4-n-butoxynaphthalen-1-yl)tetrahydrothiophenium perfluoro-n-octanesulfonate, 1-(4-n-butoxynaphtbalen-1-yl)tetrahydrothiophenium 2-bicyclo[2.2.1]hept-2-yl-1,1,2,2-tetrafluoroethanesulfonate, and 1-(4-n-butoxynaphthalen-1-yl)tetrahydrothiophenium camphorsulfonate;

1-(6-n-butoxynaphthaten-2-yl)tetrahydrothiophenium salt compounds such as 1-(6-n-butoxynaphthalen-2-yl)tetrahydrothiophenium trifluoromethanesulfonate, 1-(6-n-butoxynaphthalen-2-yl)tetrahydrothiophenium nonafluoro-n-butanesuffanate, 1-(6-n-butoxynaphthalen-2-yl)tetrahydrothiophenium perfluoro-n-octanesulfonate, 1-(6-n-butoxynaphthalen-Z-yl)tetrahydrothiophenium 2-bicyclo[2.2.1]hept-2-yl-1,1,2,2-tetrafluoroethanesulfonate, and 1-(6-n-butoxynaphthalen-2-yl)tetrahydrothiophenium camphorsulfonate;

1-(3,5-dimethyl-4-hydroxyphenyl)tetrahydrothiophenium salt compounds such as 1-(3,5-dimethyl-4-hydroxyphonyl)tetrahydrothiophenium trifluoromethanesulfonate, 1-(3,5-dimethyl-4-hydroxypheayl)tetrahydrothiophenium nonafluoro-n-butanesulfonate, 1-(3,5-dimethyl-4-hydroxyphenyl)tetrahydrothiophenium perfluoro-n-octanesulfonate, 1-(3,5-dimethyl-4-hydroxyphenyl)tetrahydrothiophenium 2-bicyclo[2.2.1]hept-2-yl-1,1,2,2-tetrafluoroethanesulfonate and 1-(3,5-dimethyl-4-hydroxyphenyl)tetrahydrothiophenium camphorsulfonate;

bicyclo[2.2.1]hept-5-ene-2,3-dicarboxyimide compounds such as N-(trifluoromethanesulfonyloxy)bicyclo[2.2.1]hept-5-ene-2,3-dicarboxyimide, N-(nonafluoro-n-butanesulfonyloxy)bicyclo[2.2.1]hept-5-ene-2,3-dicarboxymide, N-(perfluoro-n-octanesulfonyloxy)bicyclo[2.2.1]hept-5-ene-2,3-dicarboxyimide, N-(2-bicyclo[2.2,1]hept-2-yl-1,1,2,2-tetrafluoroethanesulfonyloxy)bicydo[2.2.1]hept-5-ene-2,3-dicarboxyimide, N-(2-(3-tetracyclo[4.4.0.1^{2,5}.1^{7,10}]dodecanyl)-1,1-difluoroethanesulfonyloxy)bicyclo [2.2.1]hept-5-ene-2,3-dicarboxyimide, and N-(camphorsulfonyloxy)bicyclo[2.2.1]hept-5-ene-2,3-dicarboxyimide; and the like can be given.

Other specific preferable examples of the acid generator include compounds of the following formulas B1 to B15.

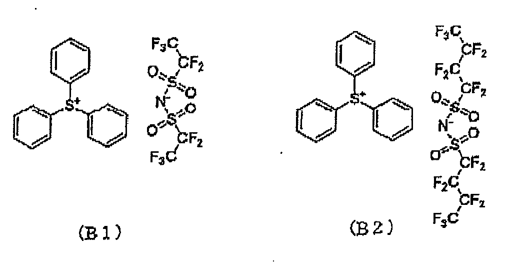

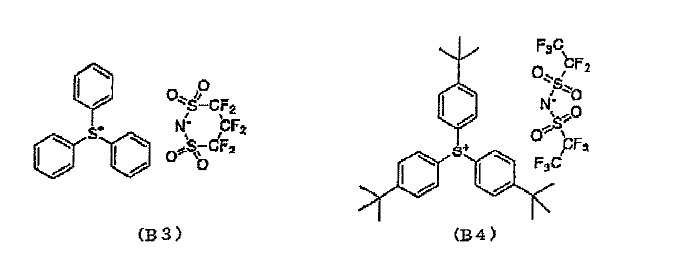

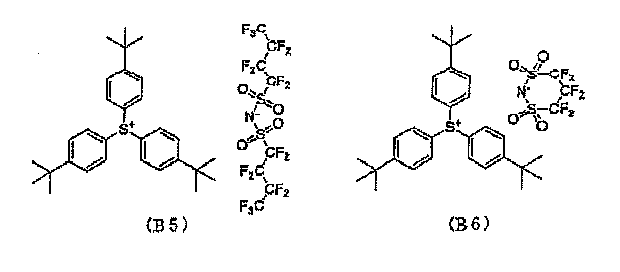

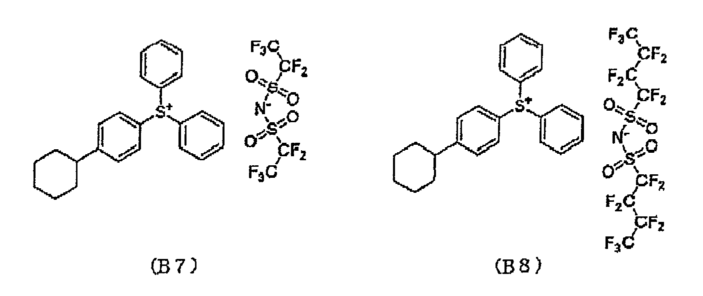

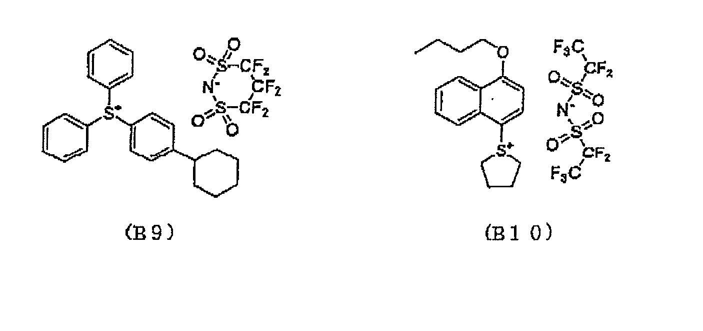

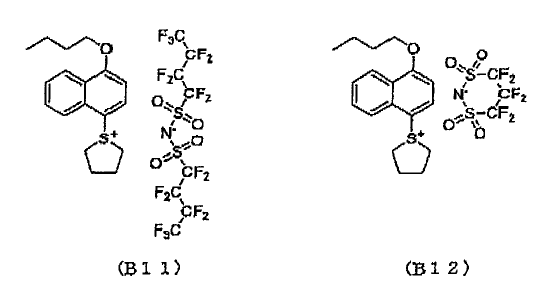

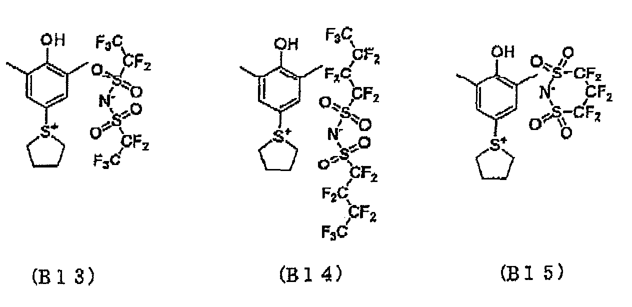

These acid generators can be used either individually or in combination of two or more.

In the present embodiment, the acid generators (C) can be used either individually or in combination of two or more. The amount of the acid generator (C) to be used is preferably 0.1 to 30 parts by mass, and more preferably 0.1 to 20 parts by mass for 100 parts by mass of the polymer (A) from the viewpoint of ensuring sensitivity and developability as a resist. If the amount of the acid generator is less than 0.1 part by mass, sensitivity and developability may be decreased, If the amount exceeds 30 parts by mass, a rectangular resist pattern may not be obtained due to decreased transparency to radiation.

### (Other additives)

Various types of additives such as acid diffusion controllers, alicyclic additives having an acid-dissociable group, alicyclic additives having no acid-dissociable group, surfactants, and sensitizers may optionally be added to the radiation-sensitive resin composition of the present invention.

The acid diffusion controllers control diffusion of an acid generated from the acid generator (C) upon irradiation in the resist film to suppress undesired chemical reactions in the non-irradiated area. Addition of the acid diffusion controller further improves storage stability of the resulting radiation-sensitive resin composition and resolution of the resist. Moreover, the addition of the acid diffusion controller prevents the line width of the resist pattern from changing due to changes in the post-exposure delay (FED) between irradiation and development, whereby a composition with remarkably superior process stability can be obtained. As the acid diffusion controller, nitrogen-containing organic compounds of which the basicity does not change during irradiation or heating when forming a resist pattern are preferable.

As preferable examples of the nitrogen-containing organic compound, tertiary amine compounds, amide group-containing compounds, quaternary ammonium hydroxide compounds, and nitrogen-containing heterocyclic compounds can be given.

Examples of the tertiary amine compound include tri(cyclo)alkylamines such as triethylamine, tri-n-propylamine, tri-n-butylamine, tri-n-pentylamine, tri-n-hexylamine, tri-n-heptylamine, tri-n-octylamine, cyclohexyldimethylamine, and tricyclohexylamine; alkanolamines such as triethanolamine and diethanolaniline; N,N,N',N'-tetramethylethylenediamine, N,N,N',N'-tetrakis(2-hydroxypropyl)ethylenediamine, 1,3-bis[1-(4-aminophenyl)-1-methylethyl]benzenetetramethylenediamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, 1,3-bis[1-(4-aminophenyl)-1-methylethyl]benzene, bis(2-dimethylaminoethyl) ether, bis(2-diethylaminoethyl) ether, and the like.

As preferable examples of the amide group-containing compounds, in addition to N-t-butoxycarbonyl group-containing amino compounds such as N-t-butoxycarbonyldi-n-octylamine, N-t-butoxycarbonyldi-n-nonylamine, N-t-butoxycarbonyldi-n-decylamine, N-t-butoxycarbonyldicyclohexylamine, N-t-butoxycarbonyl-1-adamantylamine, N-t-butoxycarbonyl-N-methyl-1-adamantylamine, N,N-di-t-butoxycarbonyl-1-adamantylamine, N,N-di-t-butoxycarbonyl-N-methyl-1-adamantylamine, N-t-butoxycarbonyl-4,4'-diaminodiphenylmethane, N,N'-di-t-butoxycarbonylhexamethylenediamine, N,N,N'N'-tetra-t-butoxycarbonylhexamethylenediamine, NN'-di-t-butoxycarbonyl-1,7-diaminoheptane, N,N'-di-t-butoxycarbonyl-1,8-diaminooctane N,N'-di-t-butoxycarbonyl-1,9-diaminononane, N,N'-di-t-butoxycarbonyl-1,10-diaminodecane, N,N'-di-t-butoxycarbonyl-1,12-diaminododecane, N,N'-di-t-butoxycarbonyl-4,4'-dianinodiphenylmethane, N-t-butoxycarbonylbenzimidazole, N-t-butoxycarbonyl-2-methylbenzimidazole, N-t-butoxycarbonyl-2-phenylbenzimidazole, N-t-butoxycarbonylpyrrolidine, N-t-butoxycarbonylpiperidine, N-t-butoxycarbonyl-4-hydroxypiperidine, and N-t-butoxycarbonylmoxpholine, formamide, N-methylformamide, N,N-dimethylformamide, acetamide, N-methylacetamide, N,N-dimethylacetamide, propionamide, benzamide, pyrrolidone, N-methylpyrrolidone, and the like can be given.

As preferable examples of the quaternary ammonium hydroxide compound, tetramethylammonium hydroxide, tetraethylammonium hydroxide, tetra-n-propylammonium hydroxide, tetra-n-butylammonium hydroxide, and the like can be given.

Preferable examples of the nitrogen-containing heterocyclic compound include: in addition to imidazoles such as imidazole, 4-methylimidazole, 1-benzyl-2-methylimidazole, 4-methyl-2-phenylimidazole, benzimidazole, and 2-phenylbenzimidazole and piperazines such as piperazine, 1-(2-hydroxyethyl)piperazine; pyrazine, pyrazole, pyridazine, quinoxaline, purine; pyrrolidine such as t-butyl-1-pyrrolidine carboxylate; piperidines such as t-butyl-4-hydroxy-1-piperidine carboxylate; 3-piperidino-1,2-propanediol, morpholine, 4-methylmorphaliae, 1,4-dimethylpiperazine, and 1,4-diazabicyclo[2.2.2]octane.

The acid diffusion controller may be used either individually or in combination of two or more. The acid diffusion controller is preferably used in an amount of 0.001 to 15 parts by mass, particularly preferably 0.01 to 10 parts by mass, and even more preferably 0.1 to 5 parts by mass for 100 parts by mass of the polymer (A). If the amount of the acid diffusion controller exceeds 15 parts by mass, sensitivity as a resist and developability of the irradiated area tend to decrease. If the amount is less than 0.001 part by mass, the pattern configuration or dimensional accuracy as a resist may decrease depending on the processing conditions.

The alicyclic additives having an acid-dissociable group and alicyclic additives having no acid-dissociable group improve dry etching resistance, pattern configuration, adhesion to the substrate, and the like.

As examples of such alicyclic additives, adamantane derivatives such as t-butyl 1-adamantanecarboxylate, t-butoxycarbonylmethyl 1-adamantanecarboxylate, α-butyrolactone 1-admnantanecarboxylate, di-t-butyl 1,3-adamantanedicarboxylate, t-butyl 1-adamantaneacetate, t-butoxycarbonylmethyl 1-adamantaneacetate, di-t-butyl 1,3-adamantanediacetate, and 2,5-dimethyl-2,5-di(adamantylcarbonyloxy)hexane; deoxycholates such as t-butyl deoxycholate, t-butoxycarbonylmethyl deoxycholate, 2-ethoxyethyl deoxycholate, 2-cyclohexyloxyethyl deoxycholate, 3-oxocyclohexyl deoxycholate, tetrahydropyranyl deoxycholate, and mevalonolactone deoxycholate; lithocholates such as t-butyl lithocholate, t-butoxycarbonylmethyl lithocholate, 2-ethoxyethyl lithocholate, 2-cyclohexyloxyethyl lithocholate, 3-oxocyclohexyl lithocholate, tetrahydropyranyl lithocholate, and mevalonolactone lithocholate; alkylcarboxylates such as dimethyl adipate, diethyl adipate, dipropyl adipate, di-n-butyl adipate, and di-t-butyl adipate; and the like can be given. These alicyclic additives may be used either individually or in combination of two or more. The alicyclic additives are preferably used in an amount of 50 parts by mass or less and particularly preferably 30 parts by mass or less for 100 parts by mass of the polymer (A). If the amount of the alicyclic additives exceeds 50 parts by mass, heat resistance as a resist tends to decrease.

The surfactants as an additive improve applicability, striation, developability, and the like. As examples of the surfactant, nonionic surfactants such as polyoxyethylene lauryl ether, polyoxyethylene stearyl ether, polyoxyethylene oleyl ether, polyoxyethylene n-octyl phenyl ether, polyoxyethylene n-naztyl phenyl ether, polyethylene glycol dilaurate, and polyethylene glycol distearate; and commercially available products such as KP341 (manufactured by Shin-Etsu Chemical Co., Ltd.), POLYFLOW No. 75, No. 95 (manufactured by Kyoeisha Chemical Co., Ltd.), FTOP EP301, EF303, EF352 (manufactured by Tohkem Products Corporation), MEGAFAC F171, F173 (manufactured by Dainippon Ink and Chemicals, Inc.), Fluorad FC430, FC431 (manufactured by Sumitomo 3M Ltd.), Asahi Guard AG710, and Surflon S-382, SC-101, SC-102, SC-103, SC-104, SC-105, SC-106 (manufactured by Asahi Glass Co., Ltd.) can be given. The surfactants may be used either individually or in combination of two or more. The surfactants are preferably used in an amount of 2 parts by mass or less for 100 parts by mass of the acid-dissociable group containing polymer.

Although the additives (B) function as a photosensitizer, the radiation-sensitive resin composition of the present embodiment may comprise other photosensitizers as other additives. The other photosensitizers, in the same manner as the additives (B), absorb radiation energy and transmit the energy to the acid generator, thereby increasing the amount of the generated acid and improving apparent sensitivity of the radiation-sensitive resin composition. As examples of the other photosensitizers, carbazoles, benzophenones, rose bengals, anthracenes, phenols, and the like can be given. These other photosensitizers may be used either individually or in combination of two or more. The other photosensitizers are preferably used in an amount of 50 parts by mass or less for 100 parts by mass of the polymer (A).

As examples of other additives, halation inhibitors, adhesion promoters, storage stabilizers, anti-foaming agents, and the like can be given.

### (Method for preparing polymer (A))

Although there are no limitations to the method for preparing the polymer (A) of the radiation-sensitive resin composition of the present invention, the polymer can be prepared by, for example, causing polymerizable unsaturated monomers corresponding to the recurring units for forming a desired molecular composition to polymerize in a suitable solvent in the presence of a radical polymerization initiator, chain transfer agent, and the like. In order to realize a sufficient rate of polymerization, the radical polymerization initiator is preferably added at a sufficiently high concentration. However, if the amount of the radical polymerization initiator is too great in relation to the amount of the chain transfer agent, a radical-radical coupling reaction occurs, resulting in the formation of an undesirable non-livitng radical polymer, which causes a part of the obtained polymer to have uncontrolled polymer characteristics such as molecular weight and molecular weight distribution. The mol ratio of the radical polymerization initiator to the chain transfer agent is preferably 1:1 to 0.005:1.

Although there are no limitations to the above radical polymerization initiator, a thermal polymerization initiator, redox polymerization initiator, and photo-polymerization initiator can be given as examples. As specific examples of the radical polymerization initiator, initiators such as peroxides and azo compounds can be given. More specific radical polymerization initiators include, t-butyl hydroperoxide, t-butyl perbenzoate, benzoyl peroxide, 2.2'-azobis(2,4-dimethylvaleronitrile), 2,2'-azobisisobutyronitrile (AIBN), 1,1'-azobis(cyclohexanecarbonitrile), dimethyl 2,2'-azobisisobutyrate (MAIB), and the like.

As the chain transfer agent, pyrazole derivatives, alkyl thiols, and the like can be given.

As the method of polymerization, commonly used batch polymerization, dripping polymerization, and the like can be given. For example, specific monomers corresponding to the above recurring unit (1-1), recurring unit (1-2), and other recurring units are dissolved in an organic solvent in a necessary amount and polymerization is conducted in the presence of a radical polymerization initiator and chain transfer agent to obtain the polymer (A). An organic solvent capable of dissolving the monomers, radical polymerization initiator, and chain transfer agent is generally used as the polymerization solvent. As examples of the organic solvent, ketones, ethers, aprotic polar solvents, esters, aromatic solvents, and linear or cyclic aliphatic solvents can be given. Specific examples of the ketones include methyl ethyl ketone, acetone, 4-methyl-2-pentanone, 2-heptanone, and the like. Examples of the ethers include alkoxyalkyl ether, such as methoxymethyl ether, ethyl ether, tetrahydrofuran, and 1,4-dioxane. Examples of the aprotic polar solvents include dimethylformamide, dimethyl sulfoxide, and the like. Examples of the esters include alkyl acetates such as ethyl acetate, methyl acetate, n-butyl acetate, i-butyl acetate, methyl propionate, and the like. Examples of the aromatic solvents include benzene, alkylaryl solvent, for example, toluene, xylene, ethylbenzene, cumene, and halogenated aromatic solvents such as chlorobenzene. Examples of the aliphatic solvents include hexane, cyclohexane, and the like. These solvents may be used either individually or in combination of two or more.

The polymerization temperature is usually 40 to 150°C, preferably 50 to 120°C, and still more preferably 60 to 120°C. Although polymerization may also be conducted in a normal atmosphere, polymerization is preferably conducted in an inert gas atmosphere such as nitrogen and argon. The molecular weight of the polymer (A) can be adjusted by controlling the ratio of the monomers and the chain transfer agent. The polymerization time is usually 0.5 to 144 hours, preferably 1 to 72 hours, and still more preferably 2 to 24 hours.

The polymer (A) may or may not have a residue originating from a chain transfer agent in the melccular chain end, or may have only a part of the chain transfer agent residue in the molecular chain end.

Needless to mention of a content of impurities such as metals, it is desirable that the content of residual monomers and oligomer components in the polymer Abe not more than a specified amount, for example, 0.1 mass% or less when measured by HPLC. This not only further improves sensitivity, resolution, process stability, pattern configuration, and the like as a resist, but also enables provision of a radiation-sensitive resin composition usable as a resist having little foreign matter in the solution and showing little change in sensitivity over time.

As examples of the purification method for the polymer (A), the fallowing methods can be given. As a method for removing impurities such as metals, a method of adsorbing metals in the polymer (A) solution using a zeta-potential filter, a method of transforming the metals into a chelate state by washing the polymer (A) solution with an acidic aqueous solution such as oxalic acid or sulfonic acid and removing the metals, and the like can be given. As a method for removing the residual monomers and oligomer components to reduce the content of these components to a specific value or less, a liquid-liquid extraction method in which the residual monomers and oligomer components are removed by combining washing with water and a suitable solvent, a purification method in a solution state such as ultrafiltration in which only the components having a specific molecular weight or less are extracted and removed, a reprecipitation method in which the residual monomers and the like are removed by adding the polymer (A) solution to a poor solvent dropwise, thereby causing the polymer (A) to coagulate in the poor solvent, a purification method in a solid state in which the polymer slurry separated by filtration is washed with a poor solvent, and the like can be given. These methods may be used in combination. The type of the poor solvent used in the reprecipitation method varies depending on the properties of the polymer (A) to be purified and the like. A person skilled in the art can suitably select the type of poor solvent based on the properties of the polymer.

The polystyrene-reduced weight average molecular weight (hereinafter referred to as "Mw") of the polymer (A) determined by gel permeation chromatography (GPC) is usually from 1,000 to 300,000, preferably from 2,000 to 300,000, and particularly preferably from 2,000 to 12,000. If the Mw of the polymer (A) is less than 1,000, heat resistance as a resist may be decreased. If the Mw exceeds 300,000, developability as a resist may be decreased.

The ratio of Mw to the polystyrene-reduced number average molecular weight (hereinafter referred to as "Mn") determined by gel permeation chromatography (GPC) (Mw/Mn) of the polymer (A) is preferably from 1 to 5, particularly preferably from 1 to 3, and even more preferably from 1 to 1.6.

Based on the intended use, the radiation-sensitive resin composition of the present invention is usually made into a composition solution by dissolving the composition in a solvent so that the total solid content is usually from 3 to 50 mass%, and preferably from 5 to 25 mass%, and filtering the solution using a filter with a pore diameter of about 0.2 µm, for example. As solvents used for preparing the radiation-sensitive resin composition solution, in addition to linear or branched ketones such as 2-pentanone, 2-hexanone, 2-heptanone, and 2-octanone; cyclic ketones such as cyclopentanone and cyclohexanone; propylene glycol monoalkyl ether acetates such as propylene glycol monomethyl ether acetate and propylene glycol monoethyl ether acetate; alkyl 2-hydroxypropionates such as methyl 2-hydroxypropionate and ethyl 2-hydroxypropionate; and alkyl 3-alkoxypropionates such as methyl 3-methoxypropionate, ethyl 3-methoxypropionate, methyl 3-ethoxypropionate, and ethyl 3-ethoxypropionate; ethylene glycol monomethyl ether, ethylene glycol monoethyl ether, diethylene glycol dimethyl ether, diethylene glycol diethyl ether, ethylene glycol monomethyl ether acetate, ethylene glycol monoethyl ether acetate, propylene glycol monomethyl ether, propylene glycol monoethyl ether, n-butyl acetate, methyl pyruvate, ethyl pyruvate, N-mcthylpyrrolidonc, γ-butyrolactone, and the like can be given.

Although these solvents may be used either individually or in combination of two or more, inclusion of at least one of the solvents selected from propylene glycol monomethyl ether acetate, propylene glycol monomethyl ether, 2-heptanone, cyclohexanone, γ-butyrolactone, ethyl 2-hydroxypropionate, and ethyl 3-ethoxypropionate is preferable.

### (Formation of resist pattern)

A resist pattern is farmed from the radiation-sensitive resin composition of the present invention by applying the composition solution thus prepared to, for example, substrates such as a silicon wafer or a wafer coated with aluminum using an appropriate application method such as rotational coating, cast coating, and roll coating to form a resist film. Then, after optional heat treatment (hereinafter referred to as "PB"), the resist film is exposed to radiation through a mask with a prescribed pattern. A liquid immersion lithographic method may be used as the exposure here.

As a radiation that can be used here, deep ultraviolet rays such as a bright line spectrum of a mercury lamp (wavelength: 254 nm), KrF excimer laser (wavelength: 248 nm), ArF excimer laser (wavelength; 193 nm), F₂ excimer laser (wavelength: 157 nm), and EUV (wavelength: 13 nm); X-rays such as synchrotron radiation, charged particle rays such as electron beams, and the like can be used according to the types of acid generator (A), with deep ultraviolet rays and charged particle rays being preferable and KrF excimer laser (wavelength: 248 um), ArF excimer laser (wavelength: 193 nm), and electron beams being particularly preferable. The exposure conditions such as the dose of radiation are appropriately determined according to the composition of the radiation-sensitive resin composition, types of additives, and the like.

In the formation of the resist pattern, the coatings are preferably post-baked after exposure to radiation (hereinafter referred to as "PEB") to increase the apparent sensitivity of the resist. PEB is performed at a temperature of 3 0 to 200°C, and preferably 50 to 150°C, although the temperature varies depending on the composition of the radiation-sensitive resin composition, types of additives, and the like.

The resist film after exposure is developed in an alkaline developer to form a predetermined resist pattern. As the alkaline developer, an alkaline aqueous solution in which one or more alkaline compounds such as an alkaline metal hydroxide, aqueous ammonia, alkylamines, alkanolamines, heterocyclic amines, tetraalkylammonium hydroxides, choline, 1,8-diazabicyclo[5.4.0]-7-undecene, and 1,5-diazabicyclo[4.3.0]-5-nonene are dissolved is used. An aqueous solution of tetraalkylammonium hydroxide is a particularly preferable alkaline developer. The concentration of the alkaline aqueous solution is preferably 10 mass% or less, more preferably 1 to 10 mass%, and particularly preferably 2 to 5 mass%. The concentration of the alkaline aqueous solution not greater than 10 mass% prevents dissolution of an unexposed area in the developer. The addition of an appropriate amount of a surfactant and the like to the alkaline developer is desirable to increase wettability of the resist to the developer. The resist film is generally washed with water and dried after development using the alkaline developer.

### EXAMPLES

The present invention will be described below in more detail by way of examples. The present invention, however, is not limited to the following examples. In the examples, "part" refers to "part by mass" unless otherwise indicated.

Measurement and evaluation in the examples and comparative examples were carried out according to the following procedures.

### (Mw)

Mw was measured by gel permeation chromatography (GPC) using GPC columns (manufactured by Tosoh Corp., G2000HXL × 2, G3000HXL × 1, G4000HXL × 1) under the following conditions. Flow rate: 1.0 ml/minute, eluate: tetrahydrofuran, column temperature: 40°C, standard reference material: monodispersed polystyrene

### (Sensitivity)

Each composition solution was applied to a silicon wafer with a 780 Å-thick ARC29 film (manufactured by Brewer Science Corp.) coated on the surface by spin coating and pre-baked (PB) on a hot plate under the conditions shown in Table 2 to obtain a resist coating with a thickness of 0.20 µm. The coating was exposed to a radiation through a mask pattern using an ArF excimer laser exposure apparatus (manufactured by Nikon Corp., lens numerical aperture: 0.75). After PEB under the conditions shown in Table 2, the resist films were developed in a 2.38 mass% tetramethylammonium hydroxide aqueous solution at 25°C, washed with water, and dried to form a positive-tone resist pattern. An optimum dose at which a line-and-space (1L1S) pattern with a line width of 0.090 µm was formed was taken as sensitivity.

### (Resolution)

Minimum dimensions of the resist pattern resolved at the optimum dose were taken as the resolution.

### (Pattern profile)

The dimensions of the lower side L_{b} and the upper side Lₐ of the rectangular cross section of a line and space pattern (1L1 S) with a line width of 0.090 µm were measured using a scanning electron microscope. A pattern shape which satisfied the formula 0.85 ≤Lₐ/L_{b} ≤ 1 and was straight with no extended skirt was evaluated as "Good". When 0.85 > Lₐ/L_{b} was satisfied, the pattern shape was evaluated as "Bad".

### (Line edge roughness (LER))

Line widths of 90 nm (1L1S) patterns resolved at an optimum exposure dose were observed from upside using SEM "S9220" manufactured by Hitachi Ltd, at optional points and variations were expressed by 3-Sigma. The LER was judged as "Bad" if the value was 10 nm or more, and as "Good" if the value was less than 10 nm.

### (Adhesion)

90 nm (1L1S) patterns were inspected as the line width was progressively reduced by increasing the exposure dose starting from the optimum exposure dose. The adhesion was judged as "Good" if the line width immediately before pattern collapsing was less than 75 nm, and as "Bad" if 75 nm or more.

### Synthesis of naphthalene-based alkoxy substituted compound (B-2)

### (Synthesis Example 1)

A 1,000 ml eggplant-like flask equipped with a stirrer and a reflux condenser was charged with 10 g of 1-hydroxynaphthalene, 20 g of t-butyl bromoacetate, 15 g of potassium carbonate, and 500 g of acetone. The mixture was reacted for 10 hours at 40°C in a nitrogen gas atmosphere. After the reaction, the reaction mixture was added to a separating funnel together with 500 g of ethyl acetate and washed three times with 500 g of water. After washing, the resulting solution was concentrated and dried at 50°C for 17 hours to obtain 14 g of 1- t-butoxycarbonylmethoxynaphthalene of the following formula (7).

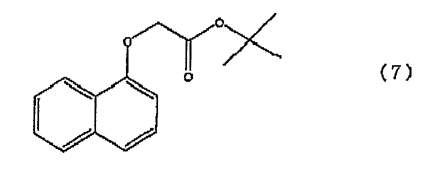

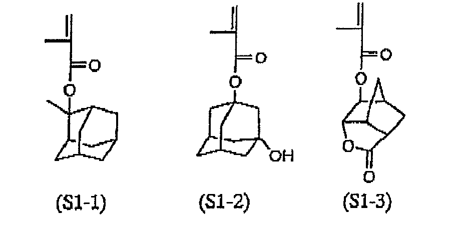

### (Synthesis Example 2)

A monomer solution was prepared by dissolving 35.88 g (35 mol%) of the compound (S1-1), 15.51 g (15 mol%) of the compound (S1-2), and 48.61 g (50 mol%) of the compound (S1-3) in 200 g of 2-butanone and adding 4.03 g of dimethyl 2,2'-azobis(2-methylpropionate) to the solution. A 1,000 ml three-neck flask charged with 100 g of 2-butanone was purged with nitrogen for 30 minutes. After nitrogen purge, the flask was heated to 80°C and the above monomer solution was added dropwise with stirring using a dripping funnel at a rate of 10 ml/5 min. The polymerization reaction was carried out for six hours after initiation of dripping. After completion of polymerization, the polymer solution was cooled with water to 30°C or lower and poured into 2,000 g of methanol. White precipitate powder produced was collected by filtration. The white powder collected by filtration was washed twice with 400 g of methanol in a slurry state, again filtered, and dried at 50°C for 17 hours to obtain a white resin powder (74 g, yield: 74%). The resin was found to have a molecular weight of 9,800 and to be a copolymer containing recurring units of the compound (S1-1), the compound (S1-2), and the compound (S1-3) at a ratio of 35.8:13.2:51.0(mol%). This resin is called a "resin (A-1)".

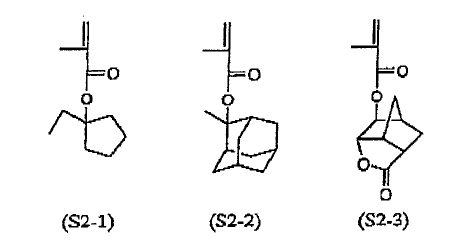

### Synthesis Example 3

A monomer solution was prepared by dissolving 10.70 g (13 mol%) of the compound (S2-1), 39.14 g (37 mol%) of the compound (S2-2), and 50.16 g (50 mol%) of the compound (S2-3) in 200 g of 2-butanone and adding 1.52 g of 2,2'-azobisisobutylonitrile to the solution. A 1,000 ml three-neck flask charged with 100 g of 2-butanone was purged with nitrogen for 30 minutes. After nitrogen purge, the flask was heated to 80°C and the above monomer solution was added dropwise with stirring using a dripping funnel at a rate of 10 ml/5 min. The polymerization reaction was carried out for six hours after initiation of dripping. After completion of polymerization, the polymer solution was cooled with water to 30°C or lower and poured into 2,000 g of methanol. White precipitate powder produced was collected by filtration. The white powder collected by filtration was washed twice with 400 g of methanol in a slurry state, again filtered, and dried at 50°C for 17 hours to obtain a white resin powder (78 g, yield: 78%). The resin was found to have a molecular weight of 8,700 and to be a copolymer containing recurring units of the compound (S2-1), the compound (S2-2), and the compound (S2-3) at a ratio of 14.7:34.2:51.1 (mol%). This resin is referred to as a "resin (A-2)".

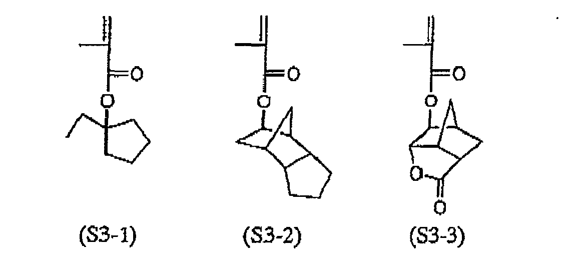

### (Synthesis Example 4)

A monomer solution was prepared by dissolving 35.38 g (40 mol%) of the compound (S3-1), 10.69 g (10 mol%) of the compound (S3-2), and 53.93 g (50 mol%) of the compound (S3-3) in 200 g of 2-butanone and adding 5.59 g of dimethyl 2,2'-azobis(2-methylpropionate) to the solution. A 1,000 ml three-neck flask charged with 100 g of 2-butanone was purged with nitrogen for 30 minutes. After nitrogen purge, the flask was heated to 80°C and the above monomer solution was added dropwise with stirring using a dripping funnel at a rate of 10 ml/5 min. The polymerization reaction was carried out for six hours after initiation of dripping. After completion of polymerization, the polymer solution was cooled with water to 30°C or lower and poured into 2,000 g of methanol. White precipitate powder produced was collected by filtration. The white powder collected by filtration was washed twice with 400 g of methanol in a slurry state, again filtered, and dried at 50°C for 17 hours to obtain a white resin powder (81 g, yield: 81 %). The resin was found to have a molecular weight of 6,600 and to be a copolymer containing recurring units of the compound (S3-1), the compound (S3-2), and the compound (S3-3) at a ratio of 39.8:7.7:52.5 (mol%). This resin is called a "resin (A-3)".

Radiation-sensitive resin composition solutions shown in Examples 1-8 and Comparative Example 1 were prepared. The components other than the resins (A-1) to (A-3) were as follows. Compositions of the radiation-sensitive resin composition solutions are shown in Table 1.

### (Additive (B))

(B-1): 1-butoxynaphthalene
(B-2): 1-t-butoxycarbanylmethoxynaphthalene
(B-3): 1,5-hydroxynaphthalene
(B-4): 2-naphthoic acid
(B-5): t-butoxycarbonylmethyl lithocholate
(B-6): 1,1,1,3,3,3-hexafluoro-2-(tetracyclo[6.2.1.1^{3,6}0^{2,7}]dodecan-4-ylmethyl)-2-propanol,

### (Acid generator (C))

(C-1): triphenylsulfonium nonafluoro-n-butanesulfonate
(C-2): 1-(4-n-butoxynaphthalene-1-yl)tetrahydrothiophenium nonafluoro-n-butanesulfonate
(C-3): 1-(4-n-butoxynaphthalene-1-yl)tetrahydrothiophenium 2-norbornanetetrafluoroethanesulfonate
(C-4): 4-cyclohexylphenyldiphenylsulfonium nonafluorobutanesulfonate

### (Acid diffusion controller (D))

(D-1): 2-phenylbenzimidazole
(D-2): t-butyl 1-pyrrolidinecarboxylate
(D-3): t-butyl 4-hydroxy-1-piperidinecarboxylate

### (Solvent (E))

(E-1): propylene glycol monomethyl ether acetate
(E-2): cyclohexanone
E-3: γ-butyrolactone

### (Example 1)

A radiation-sensitive resin composition was prepared by mixing 100 parts of resin (A-1), 2 parts of additive (B-1), 1 part of acid generator (C-1), 4 parts of acid generator (C-2), 2 parts of acid generator (C-3), 0.75 part of acid diffusion controller (D-1), 870 parts of solvent (E-1), and 30 parts of solvent (E-2).

### (Example 2)

A radiation-sensitive resin composition was prepared in same manner as in Example 1, except for using additive (B-2) instead of the additive (B-1).

### (Example 3)

A radiation-sensitive resin composition was prepared by mixing 100 parts of resin (A-2), 2 parts of additive (B-1), 4 parts of additive (B-5), 4 parts of acid generator (C-3), I part of acid generator (C-4), 0.50 part of acid diffusion controller (D-2), 630 parts of solvent (E-1), and 270 parts of solvent (E-2).

### (Example 4)

A radiation-sensitive resin composition was prepared in same manner as in Example 3, except for using additive (B-2) instead of the additive (B-1).

### (Example 5)

A radiation-sensitive resin composition was prepared in same manner as in Example 3, except for using additive (B-3) instead of the additive (B-1).

### (Example 6)

A radiation-sensitive resin composition was prepared in same manner as in Example 3, except for using additive (B-4) instead of the additive (B-1).

### (Example 7)

A radiation-sensitive resin composition was prepared by mixing 100 parts of resin (A-3), 2 parts of additive (B-1), 2 parts of acid generator (B-6), 2.5 parts of acid generator (C-1), 2 parts of acid generator (C-2), 0.60 part of acid diffusion controller (D-3), 870 parts of solvent (E-1), and 30 parts of solvent (E-2).

### (Example 8)

A radiation-sensitive resin composition was prepared in same manner as in Example 7, except for using additive (B-2) instead of the additive (B-1).

### (Comparative Example 1)

A radiation-sensitive resin composition was prepared in same manner as in Example 1, except for not using additive (B-1) and using 0.60 part of the acid diffusion controller (D-1).

The radiation-sensitive resin composition solutions prepared were subjected to various evaluations. The evaluation results are shown in Table 3.

**Table 1**

| | Resin (A) | Additive (B) | Acid generator (C) | Acid diffusion controller (D) | Solvent (E) |
|---|---|---|---|---|---|
| Example 1 | A-1 (100 parts) | B-1 (2 parts) | C-1 (1 part) C-2 (4 parts) C-3 (2 parts) | D-1 (0.75 part) | E-1 (870 parts) E-3 (30 parts) |
| Example 2 | A-1 (100 parts) | B-2 (2 parts) | C-1 (1 part) C-2 (4 parts) C-3 (2 parts) | D-1 (0.75 part) | E-1 (870 parts) E-3 (30 parts) |
| Comparative Example 1 | A-1 (100 parts) | None | C-1 (1 part) C-2 (4 parts) C-3 (2 parts) | D-1 (0.60 part) | E-1 (870 parts) E-3 (30 parts) |
| Example 3 | A-2 (100 parts) | B-1 (2 parts) B-5 (4 parts) | C-3 (4 parts) C-4 (1 part) | D-2 (0.50 part) | E-1 (630 parts) E-2 (270 parts) |
| Example 4 | A-2 (100 parts) | B-2 (2 parts) B-5 (4 parts) | C-3 (4 parts) C-4 (1 part) | D-2 (0.50 part) | E-1 (630 parts) E-2 (270 parts) |
| Example 5 | A-2 (100 parts) | B-3 (2 parts) B-5 (4 parts) | C-3 (4 parts) C-4 (1 part) | D-2 (0.50 part) | E-1 (630 parts) E-2 (270 parts) |
| Example 6 | A-2 (100 parts) | B-4 (2 parts) B-5 (4 parts) | C-3 (4 parts) C-4 (1 part) | D-2 (0.50 part) | E-1 (630 parts) E-2 (270 parts) |
| Example 7 | A-3 (100 parts) | B-1 (2 parts) B-6 (2 parts) | C-1 (2.5 parts) C-2 (2 parts) | D-3 (0.60 part) | E-1 (870 parts) E-3 (30 parts) |
| Example 8 | A-3 (100 parts) | B-2 (2 parts) B-6 (2 parts) | C-1 (2.5 parts) C-2 (2 parts) | D-3 (0.60 part) | E-1 (870 parts) E-3 (30 parts) |

**Table 2**

| | Thickness (µm) | Substrate | PB condition | PEB condition |
|---|---|---|---|---|
| Example 1 | 0.2 | ARC29 | 130°C - 90 sec | 130°C - 90 sec |
| Example 2 | 0.2 | ARC29 | 130°C - 90 sec | 130°C - 90 sec |
| Comparative Example 1 | 0.2 | ARC29 | 130°C - 90 sec | 130°C - 90 sec |
| Example 3 | 0.2 | ARC29 | 120°C - 60 sec | 110°C - 60 sec |
| Example 4 | 0.2 | ARC29 | 120°C - 60 sec | 110°C - 60 sec |
| Example 5 | 0.2 | ARC29 | 120°C - 60 sec | 110°C - 60 sec |
| Example 6 | 0.2 | ARC29 | 120°C - 60 sec | 110°C - 60 see |
| Example 7 | 0.2 | ARC29 | 110°C - 90 sec | 110°C - 90 sec |
| Example 8 | 0.2 | ARC29 | 110°C - 90 sec- | 110°C - 90 sec |

**Table 3**

| | Sensitivity (J/m²) | Resolution (nm) | Pattern profile | Adhesion | LER |
|---|---|---|---|---|---|
| Example 1 | 330 | 85.00 | Good | Good | Good |
| Example 2 | 330 | 85.00 | Good | Good | Good |
| Comparative Example 1 | 330 | 90.00 | Bad | Bad | Bad |
| Example 3 | 410 | 80.00 | Good | Good | Good |
| Example 4 | 410 | 80.00 | Good | Good | Good |
| Example 5 | 410 | 80.00 | Good | Good | Good |
| Example 6 | 410 | 80.00 | Good | Good | Good |
| Example 7 | 320 | 80.00 | Good | Good | Good |
| Example 8 | 320 | 80.00 | Good | Good | Good |

It can be seen from Table 3 that the radiation-sensitive resin compositions of Examples 1-8 exhibit excellent line edge roughness (LER), adhesion, pattern profile, resolution, and sensitivity. In contrast, the radiation-sensitive resin composition of Comparative Example 1, which does not contain the additive (B), showed inferior in all of these characteristics except for sensitivity.

Measurement and evaluation in the following examples and comparative examples were carried out according to the following procedures.

### (Sensitivity)

Each composition solution was applied to a silicon wafer with a 770Å thick ARC29 film (manufactured by Brewer Science Corp.) coated on the surface by spin coating and pre-baked (PB) on a hot plate under the conditions shown in Table 5 to obtain a resist coating with a thickness of 0.12 µm. The coating was exposed to radiation through a mask pattern by a liquid immersion lithographic method using water as a dipping solution and using an ArF excimer laser exposure apparatus ("TWIN SCAN XT1250i" manufactured by ASML, Ltd., verification conditions: NA = 0.85, Sigma = 0.93/0.69). After PEB under the conditions shown in Table 5, the resist films were developed in a 2.38 mass% tetramethylammonium hydroxide aqueous solution at 25°C, washed with water, and dried to form a positive-tone resist pattern. An optimum dose at which a line-and-space (1L1S) pattern with a line width of 0.075 µm was formed was taken as sensitivity.

### (Adhesion)

75 nm (1LIS) patterns were inspected as the line width was progressively reduced by increasing the exposure dose starting from the optimum exposure dose. The adhesion was judged as "Good" if the line width immediately before pattern collapse was less than 50 nm, and as "Bad" if 50 nm or more.

### (Elution)

A30 cm × 30 cm square silicone rubber sheet with a thickness of 1.0 mm (manufactured by Kureha Elastomer Co., Ltd.), from the center of which a disk with a diameter of 11.3 cm was cut out, was superposed on an 8 inch silicon wafer which was previously treated with HMDS (at 100°C for 60 seconds) using "CLEAN TRACK ACT8" (manufactured by Tokyo Electron, Ltd.), with the center of the silicone wafer being located at the center of the rubber sheet. The circular arca of the center of the silicone rubber sheet, from which a disk has been removed, was filled with 10 ml of ultra-pure water using a 10 ml whole pipette. A lower layer antireflection ARC29A film (manufactured by Brewer Science Corp.) was spin-coated on another 8 inch silicon wafer using "CLEAN TRACK ACT8" (manufactured by Tokyo Electron, Ltd.) and pre-baked (PB) at 205°C for 60 seconds to form a coating with a thickness of 77 nm. The composition solution to be evaluated was then applied by spin-coating to the substrate using "CLEAN TRACK ACT8" (manufactured by Tokyo Electron, Ltd.) and pre-baked (PB) on a hot plate under the conditions shown in Table 5 to form a resist film with a thickness of 0.12 µm. This latter 8 inch silicon wafer with a resist film formed thereon was placed on the former 8 inch silicon wafer with ultra-pure water being filled in the above cut-out area in a manner such that the resist coating may come in contact with the ultra-pure water (i.e. the surface of the resist coating may face the surface of the ultra-pure water vis-à-vis). This state was maintained for 10 seconds timed by a stopwatch, whereupon the silicon wafer was removed. After completion of the experiment, the ultra-pure water was collected using a glass injector for use as the analytical sample. The recovery rate of the ultra-pure water after completion of the experiment was 95% or more.

The photoacid generator eluted into the ultra-pure water (analytical sample) by the above-mentioned operation was analyzed by the following method. Specifically, the peak strength of the photoacid generator in the analytical sample was measured using an LC-MS system (LC section: "SERIES1100" manufactured by AGILENT, MS section: "Mariner" manufactured by Perseptive Biosystems, Inc.) and a column "CAPCELL PAK MG" × 1, manufactured by Shiseido Co., Ltd. using a 3:7 water-methanol mixture with 0.1 mass% of formic acid being added as an eluant at a flow rate of 0.2 ml/min at 35°C. A calibration curve was prepared by measuring the peak strength of 1 ppb, 10 ppb, and 100 ppb aqueous solutions of photoacid generators from the radiation-sensitive resin compositions under the above conditions. The eluted amount was calculated from the above peak strength using this calibration curve. If the eluted amount was less than 5.0 × 10⁻¹²/cm²/sec, the sample was rated as "Good"; and as "Bad" if 5.0 × 10⁻¹²/cm²/sec or more. A smaller amount of elution is preferred for the liquid immersion lithographic method.

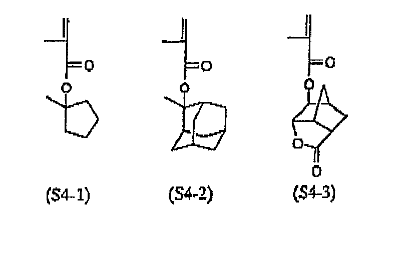

### (Synthesis Example 5)

A monomer solution was prepared by dissolving 10.70 g (13 mol%) of the compound (S4-1), 39.14 g (37 mol%) of the compound (S4-2), and 50.16 g (50 mol%) of the compound (S4-3) in 200 g of 2-butanone and adding 1.52 g of 2,2'-azobisisobutylonitrile to the solution. A 1,000 ml three-neck flask charged with 100 g of 2-butanone was purged with nitrogen for 30 minutes. After nitrogen purge, the flask was heated to 80°C and the above monomer solution was added dropwise with stirring using a dripping funnel at a rate of 10 ml/5 min. The polymerization reaction was carried out for six hours after initiation of dripping. After completion of polymerization, the polymer solution was cooled with water to 30°C or lower and poured into 2,000 g of methanol. White precipitate powder produced was collected by filtration. The white powder collected by filtration was washed twice with 400 g of methanol in a slurry state, again filtered, and dried at 50°C for 17 hours to obtain a white resin powder (78 g, yield: 78%). The resin was found to have a molecular weight of 8,700 and to be a copolymer containing recurring units of the compound (S4-1), the compound (S4-2), and the compound (S4-3) at a ratio of 14.7:34.2:51.1 (mol%). This resin is called a "resin (A-4)".

Components other than the resins (A-2) to (A-4) were as follows. Compositions of the radiation-sensitive resin composition solutions are shown in Table 4.

### (Additive (B))

(B-1): 1-butoxynaphthalene

### (Acid generator (C))

(C-1); triphenylsulfonium nonafluoro-n-butanesulfonate
(C-5): triphenylsulfonium 2-norbornanetetrafluoroethanesulfonate
(C-6): compound of the above formula "B3"

### (Acid diffusion controller (D))

(D-2): t-butyl 1-pyrrolidinecarboxylate

### (Solvent (E))

(E-1): propylene glycol monomethyl ether acetate
(E-2): cyclohexanone

### (Example 9)

A radiation-sensitive resin composition was prepared by mixing 100 parts of resin (A-4), 5 parts of additive (B-1), 5 parts of acid generator (C-1), 0,45 part of acid diffusion controller (D-2), 1,260 parts of solvent (E-1), and 540 parts of solvent (E-2).

### (Example 10)

A radiation-sensitive resin composition was prepared by mixing 100 parts of resin (A-4), 5 parts of additive (B-1), 5 parts of acid generator (C-5), 0.45 part of acid diffusion controller (D-2), 1,260 parts of solvent (E-1), and 540 parts of solvent (E-2).

### (Example 11)

A radiation-sensitive resin composition was prepared by mixing 100 parts of resin (A-4), 5 parts of additive (B-1), 5 parts of acid generator (C-6), 0.25 part of acid diffusion controller (D-2), 1,260 parts of solvent (E-1), and 540 parts of solvent (E-2).

### (Example 12)

A radiation-sensitive resin composition was prepared by mixing 100 parts of resin (A-2), 5 parts of additive (B-1), 5 parts of acid generator (C-5), 0.45 part of acid diffusion controller (D-2), 1,260 parts of solvent (E-1), and 540 parts of solvent (B-2).

### (Example 13)

A radiation-sensitive resin composition was prepared by mixing 100 parts of resin (A-3), 5 parts of additive (B-1), 5 parts of acid generator (C-5), 0.55 part of acid diffusion controller (D-2), 1,260 parts of solvent (E-1), and 540 parts of solvent (B-2).

### (Comparative Example 2)

A radiation-sensitive resin composition was prepared in same manner as in Example 10, except for not using additive (B-1).

### (Comparative Example 3)

A radiation-sensitive resin composition was prepared in same manner as in Example 10, except for not using additive (B-1) and using 7 parts of acid generator (C-5).

The radiation-sensitive resin composition solutions prepared were subjected to evaluations of sensitivity, adhesiveness, and elution. The evaluation results are shown in Table 6.

**Table 4**

| | Resin (A) | Additive (B) | Acid generator (C) | Acid diffusion controller (D) | Solvent (E) |
|---|---|---|---|---|---|
| Example 9 | A-4 (100 parte) | B-1 (5 parts) | C-1 (5 parts) | D-1 (0.75 part) | E-1 (1260 parts) E-2 (540 parts) |
| Example 10 | A-4 (100 parts) | B-1 (5 parts) | C-5 (5 parts) | D-1 (0.75 part) | E-1 (1260 parts) E-2 (540 parts) |
| Example 11 | A-4 (100 parts) | B-1 (5 parts) | C-6 (5 parts) | D-1 (0.75 part) | E-1 (1260 parts) E-2 (540 parts) |
| Example 12 | A-2 (100 parts) | B-1 (5 parts) | C-5 (5 parts) | D-1 (0.75 part) | E-1 (1260 parts) E-2 (540 parts) |
| Example 13 | A-3 (100 parts) | B-1 (5 parts) | C-5 (5 parts) | D-1 (0.75 part) | E-1 (1260 parts) E-2 (540 parts) |
| Comparative Example 2 | A-4 (100 parts) | None | C-5 (5 parts) | D-1 (0.75 part) | E-1 (1260 parts) E-2 (540 parts) |
| Comparative Example 3 | A-4 (100 parts) | None | C-5 (7 parts) | D-1 (0.75 part) | E-1 (1260 parts) E-2 (540 parts) |

**Table 5**

| | Thickness (µm) | Substrate | PB condition | PEB condition |
|---|---|---|---|---|
| Example 9 | 0.12 | ARC29 | 120°C - 90 sec | 115°C - 90 sec |
| Example 10 | 0.12 | ARC29 | 120°C - 90 sec | 115°C - 90 sec |
| Example 11 | 0.12 | ARC29 | 120°C - 90 sec | 115°C - 90 sec |
| Example 12 | 0.12 | ARC29 | ' 120°C - 90 sec | 115°C - 90 sec |
| Example 13 | 0.12 | ARC29 | 120°C - 90 sec | 115°C - 90 sec |
| Comparative Example 2 | 0.12 | ARC29 | 120°C-90 sec | 115°C - 90 sec |
| Comparative Example 3 | 0.12 | ARC29 | 120°C - 90 sec | 115°C - 90 sec |

**Table 6**

| | Sensitivity (J/m²) | Adhesion | Elution |
|---|---|---|---|
| Example 9 | 380 | Good | Good |
| Example 10 | 380 | Good | Good |
| Example 11 | 380 | Good | Good |
| Example 12 | 380 | Good | Good |
| Example 13 | 380 | Good | Good |
| Comparative Example 2 | 420 | Ead | Good |
| Comparative Example 3 | 350 | Good | Ead |

It can be seen from Table 6 that the radiation-sensitive resin compositions of Examples 9-13 showed excellent results in adhesion and elution evaluations. On the other hand, either one of adhesion performance or elution performance was poor in the radiation-sensitive resin compositions of Comparative Examples 2 and 3.

INDUSTRIAL APPLICABILITY

The radiation-sensitive resin composition of the present invention can be used as a chemically-amplified resist useful for microfabrication utilizing various types of radiation represented by deep ultraviolet rays such as a KrF excimer laser and ArF excimer laser, X-rays such as synchrotron radiation, and charged particle rays such as electron beams and is a very suitable for use in semiconductor devices which are anticipated to be further miniaturized in the future.
Aradiation-sensitive resin composition which is a resist having properties such as excellent sensitivity, a small degree of line edge roughness of patterns, capability of inhibiting pattern collapsing, and the like is provided. The radiation-sensitive resin composition comprises an acid-dissociable group-containing polymer having recurring units of the following formulas (1-1) and (1-2), an additive of the following formula (1-3), and an acid generator, 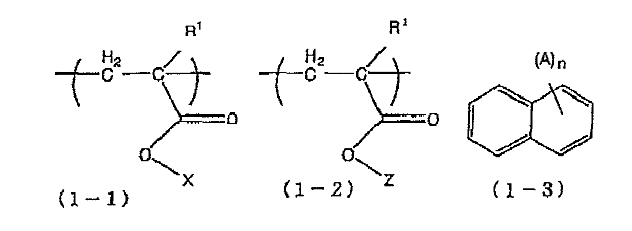 in the formula (1-1), R¹ represents a methyl group and the like and X represents a specific polycyclic alicyclic hydrocarbon group and the like, in the formula (1-2), R¹ represents a methyl group and the like and Z represents an acid-dissociable group which is dissociable by the action of an acid, and in the formula (1-3), n is an integer from 1-8 and A individually represents a hydroxyl group and the like.

## Claims

1. A radiation-sensitive resin composition comprising: (A) an acid-dissociable group-containing polymer having a recurring unit of the following formula (1-1) and a recurring unit having an acid-dissociable group of the following formula (1-2), (B) an additive of the following formula (1-3), and (C) an acid generator which generates an acid by being irradiated with radiation, 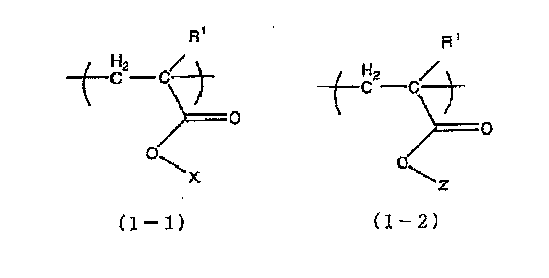 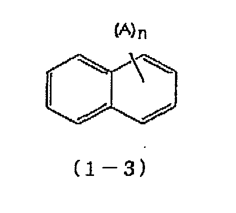 in the formula (1-1), R¹ represents a hydrogen atom, a methyl group, or a trifluoromethyl group and X represents a substituted or unsubstituted polycyclic alicyclic hydrocarbon group having 4-20 carbon atoms or a group having a lactone skeleton, in the formula (1-2), R¹ represents a hydrogen atom, a methyl group, or a trifluoromethyl group and Z represents an acid-dissociable group which is dissociable by the action of an acid, and in the formula (2-3), n is an integer from 1-8 and A individually represents a hydroxyl group and/or a monovalent organic group.

2. The radiation-sensitive resin composition according to claim 1, wherein X in the formula (1-1) is a polycyclic alicyclic hydrocarbon group having 4-20 carbon atoms, which does not contain any polar group and consists only of carbon atoms and hydrogen atoms, an adamantyl group containing a hydroxyl group in the side chain, or a group having a lactone skeleton.

3. The radiation-sensitive resin composition according to claim 1, wherein Z in the formula (1-2) is a trialkylmethyl group, an alkylcycloalkyl group, or an alkyladamantyl group.

4. The radiation-sensitive resin composition according to claim 1, wherein the acid generator which generates an acid by being irradiated with radiation is a sulfonium salt compound.

5. The radiation-sensitive resin composition according to claim 4, wherein the acid generator which generates an acid by being irradiated with radiation is contained in an amount of 0.1 to 3 0 parts by mass per 100 parts by mass of the polymer.

6. The radiation-sensitive resin composition according to claim 4, further comprising an acid diffusion controller.

7. The radiation-sensitive resin composition according to claim 6, wherein the acid diffusion controller is a compound containing an amide group.

8. The radiation-sensitive resin composition according to claim 1, wherein at least one group represented by A in the formula (1-3) is a hydroxyl group or a group represented by -O-R², wherein R² represents a linear or branched alkyl group having 1-10 carbon atoms or an alicyclic substituent having 1-10 carbon atoms.

9. The radiation-sensitive resin composition according to claim 1, wherein at least one group represented by A in the formula (1-3) is a group represented by the following formula (2), 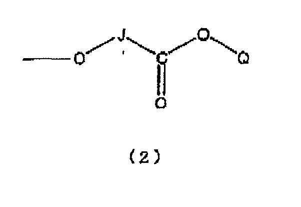 wherein J indicates a single bond, a methylene group, or a linear or branched alkylene group having 2-10 carbon atoms, and Q represents an acid-dissociable group which is dissociable by the action of an acid.

10. The radiation-sensitive resin composition according to claim 1, wherein the additive represented by the formula (1-3) is contained in an amount of 0.5 to 10 parts by mass per 100 parts by mass of the polymer.

11. A method for farming a pattern comprising irradiating the radiation-sensitive resin composition according to claim 1 with radiation by means of a liquid immersion lithographic method.
